# EUROPÄISCHE PATENTSCHRIFT

(11) **EP 0 886 147 B1**
(45) Veröffentlichungstag und Bekanntmachung des Hinweises auf die Patenterteilung: **17.09.2008**
(21) Anmeldenummer: 97112160.3
(22) Anmeldetag: 16.07.1997
(51) Int. Cl.: G01R 15/20, G01R 33/02

(54) **Anordnung zur Erzielung einer zu einem elektrischen Strom proportionalen magnetischen Induktion am Ort eines Magnetfeldsensors**
Device for obtaining a current-proportional magnetic induction at the position of a magnetic field sensor
Appareil pour obtenir une inductance magnétique proportionelle à un courant à l'emplacement d'un capteur de champ magnétique

(30) Priorität: 21.05.1997 CH 118297
(43) Veröffentlichungstag der Anmeldung: 23.12.1998
(73) Patentinhaber: Landis+Gyr AG, 6301 Zug (CH)
(72) Erfinder: Petr, Jan, 6317 Oberwil (CH); Janssen, Peter, 6313 Menzingen (CH)
(74) Vertreter: Lagler, Louis

(56) Entgegenhaltungen:
- EP-A- 0 618 451
- CH-A- 659 138
- US-A- 4 742 296
- PATENT ABSTRACTS OF JAPAN vol. 097, no. 001, 31. Januar 1997 & JP 08 241821 A (OSAKI ELECTRIC CO LTD), 17. September 1996
- PATENT ABSTRACTS OF JAPAN vol. 096, no. 005, 31. Mai 1996 & JP 08 015330 A (TOKIN CORP), 19. Januar 1996

## Beschreibung

Die Erfindung bezieht sich auf eine Anordnung zur Erzielung einer zu einem elektrischen Strom proportionalen magnetischen Induktion am Ort eines Magnetfeldsensors gemäss dem Oberbegriff des Anspruchs 1.

Die Anordnung wird vorzugsweise in einem Eingangsteil eines Einphasen- oder Mehrphasen-Elektrizitätszählers verwendet, der eine oder mehrere Arten Energie, wie z. B. Wirk- und/oder Blind- und/oder Scheinenergie misst, ggf. ergänzt durch Ermittlungen weiterer elektrischphysikalischer Parameter, wie z. B. Leistungsfaktoren und/oder Effektivwerte des elektrischen Stromes und/oder einer elektrischen Spannung. Die mittels der Anordnung erzeugte magnetische Induktion wird im Eingangsteil des Elektrizitätszählers mit einer Spannung multipliziert zwecks Erhalt einer zugehörigen elektrischen Leistung, die ihrerseits dann im Elektrizitätszähler über eine Zeit integriert wird zwecks Erhalt von zugehörigen Energiewerten. Die magnetische Induktion kann im Eingangsteil des Elektrizitätszählers auch verwendet werden zwecks Erhalt des zugehörigen Stromwertes.

Eine Anordnung der eingangs genannten Art ist aus dem Buch "Elektrische Energie elektronisch gemessen", Martin Kahmann, vde-verlag gmbh, Berlin Offenbach, 1994, Kapitel 2.10, Seiten 130 bis 137, bekannt, in dem zur Messung einer elektrischen Leistung ein zugehöriger elektrischer Strom einen U-förmigen Leiter durchfliesst und in einem Magnetkreis einen proportionalen Magnetfluss erzeugt. Der Magnetkreis besteht aus einem C-förmigen Kern aus ferromagnetischem Material., in dessen Luftspalt ein Hallelement zur Messung der elektrischen Leistung angeordnet ist.

Weiterhin ist aus der US-PS 4 749 939 ein Messwandler zum Messen eines in einem U-förmig gebogenen elektrischen Leiter fliessenden Stromes bekannt, der einen dreischenkligen ferromagnetischen Kern besitzt, dessen Mittelschenkel drei Luftspalte aufweist und vom elektrischen Leiter mindestens teilweise umgeben ist. In einem mittleren der Luftspalte ist ein Magnetfeldsensor, z. B. ein Hallelement angeordnet zum Messen des Stromes oder einer Leistung. Ein Mittelschenkel des Kerns besteht aus zwei flachen Blechstreifen, die zusammen mit dem Magnetfeldsensor in einem Gehäuse aus nichtferromagnetischem Material angeordnet sind. Die beiden äusseren Luftspalte sind durch je eine Wand des Gehäuses ausgefüllt. Ein Joch und die beiden Aussenschenkel des ferromagnetischen Kerns sind durch einen Ring gebildet, der aus einem ringförmig gebogenen ferromagnetischen Blech besteht. Der Ring ist auf seiner Mantelfläche von einer annähernd parallelen, ringförmigen Aussenabschirmung umgeben. Die durch den Ring und die Aussenabschirmung erzielte sehr gute Abschirmung des Magnetfeldsensors gegen den Einfluss äusserer magnetischer Störfelder wird erreicht auf Kosten einer relativ komplizierten und teuren Herstellung und/oder Montage des Magnetkreises mit seinem Zubehör.

Aus der US-A- 4 742 296 ist eine Anordnung zur Erzielung einer zu einem elektrischen Strom proportionalen magnetischen Induktion am Ort eines Magnetfeldsensors mit einem elektrischen Leiter zum Leiten des elektrischen Stromes und einem Magnetkreis aus ferromagnetischem Material zur Aufnahme eines durch den elektrischen Strom erzeugten Magnetflusses bekannt, wobei der Magnetkreis einen Luftspalt, der den Magnetfeldsensor enthält, sowie einen ferromagnetischen Steg aufweist, wobei zwecks Bildung eines geschlossenen Magnetkreises beide Enden des ferromagnetischen Stegs über ein erstes Mittel aus ferromagnetischem Material miteinander verbunden sind und wobei das erste Mittel mindestens zwei gegenüberliegende parallele Teilflächen aufweist, zu denen je eine Seitenfläche des ersten Mittels gehört,

Der Erfindung liegt die Aufgabe zugrunde, eine Anordnung der eingangs genannten Art zu verwirklichen, welche einfach und billig hergestellt und/oder montiert werden kann sowie eine genügend gute Abschirmung des Magnetfeldsensors gegen den Einfluss äusserer magnetischer Störfelder aufweist.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ausführungsbeispiele der Erfindung sind in der Zeichnung dargestellt und werden im folgenden näher beschrieben.

Es zeigen:
- Fig. 1: eine räumlich prinzipielle Darstellung einer ersten Variante einer erfindungsgemässen Anordnung,
- Fig. 2: eine Ansicht schräg von oben der ersten Variante in einem ersten Aufbau,
- Fig. 3: eine Ansicht schräg von unten der ersten Variante im ersten Aufbau,
- Fig. 4: eine Ansicht schräg von oben der ersten Variante in einem zweiten Aufbau,
- Fig. 5: eine Ansicht schräg von unten der ersten Variante in einem dritten Aufbau,
- Fig. 6: eine räumlich prinzipielle Darstellung einer zweiten Variante der erfindungsgemässen Anordnung,
- Fig. 7: eine räumlich prinzipielle Darstellung einer dritten Variante der erfindungsgemässen Anordnung,
- Fig. 8: eine räumlich prinzipielle Darstellung einer vierten Variante der erfindungsgemässen Anordnung,
- Fig. 9: eine räumlich prinzipielle Darstellung einer fünften Variante der erfindungsgemässen Anordnung und
- Fig. 10: eine räumlich prinzipielle Darstellung einer sechsten Variante der erfindungsgemässen Anordnung.

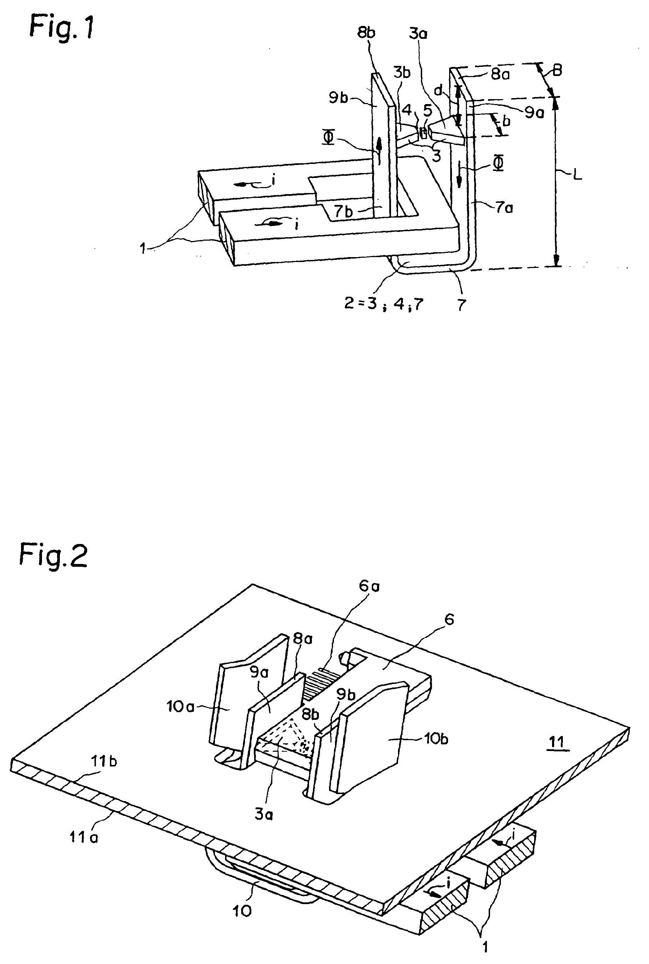

Die erfindungsgemässe Anordnung zur Erzielung einer zu einem elektrischen Strom i proportionalen magnetischen Induktion am Ort eines Magnetfeldsensors 5 ist in allen Varianten, also auch in der ersten Variante (siehe Fig. 1 bis Fig. 5), mit einem elektrischen Leiter 1 und einem Magnetkreis 2 versehen. Der elektrische Leiter 1 dient zum Leiten des elektrischen Stromes i und besitzt vorzugsweise eine spulenförmige oder U-förmige Gestalt. In der Zeichnung wurde letzteres angenommen. Der Magnetkreis 2 aus ferromagnetischem Material dient zur Aufnahme eines durch den elektrischen Strom i erzeugten Magnetflusses Φ. Er weist einen ferromagnetischen Steg 3 sowie einen Luftspalt 4 auf. Der im letzteren enthaltene Magnetfeldsensor 5, vorzugsweise ein Hallelement, dient zur Messung des elektrischen Stromes i und/oder einer diesem Strom i zugehörigen elektrischen Leistung p = v·i, wobei v eine zum Strom i gehörende elektrische Spannung darstellt. Bei der Messung der Leistung p speist, was in der Zeichnung nicht dargestellt ist, die Spannung v über einen Widerstand einen Speiseeingang des als Hallelement angenommenen Magnetfeldsensors 5. Bei der Messung des Stromes i speist dagegen, ebenfalls in der Zeichnung nicht dargestellt, eine konstante Spannung über einen Widerstand den Speiseeingang des Hallelementes. Der ferromagnetische Steg 3 ist zusammen mit dem Magnetfeldsensor 5 in einem mit elektrischen Anschlüssen 6a versehenen Gehäuse 6 aus nichtferromagnetischem Material enthalten (siche Fig. 2 bis Fig. 5). Zwecks Bildung eines geschlossenen Magnetkreises 2 sind beide Enden des ferromagnetischen Stegs 3 über ein erstes Mittel 7 aus ferromagnetischem Material miteinander verbunden. Die Breite B des ersten Mittels 7 ist grösser als die grösste Breite b des ferromagnetischen Stegs 3. Das erste Mittel 7 weist mindestens zwei gegenüberliegende parallele Teilflächen auf, zu denen je eine Seitenfläche 7a bzw. 7b des ersten Mittels 7 gehört. Die beiden Seitenflächen 7a und 7b weisen parallel zur Breite b des ferromagnetischen Stegs 3 je eine freie Kante 8a bzw. 8b auf, die jeweils ein balkonartig vorstehendes freies Ende 9a bzw. 9b der betreffenden Seitenfläche 7a bzw. 7b begrenzt. Der ferromagnetische Steg 3 ist in einem Abstand d zu den freien Kanten 8a und 8b der beiden Seitenflächen 7a und 7b und annähernd in der Mitte der Breite B des ersten Mittels 7 zwischen den parallelen Teilflächen angeordnet. Der Wert des Abstandes d, d. h. die Länge des balkonartig vorstehenden freien Endes 9a bzw. 9b der Seitenfläche 7a bzw. 7b, ist annähernd gleich 1/3 der Gesamtlänge L der Seitenfläche 7a bzw. 7b.

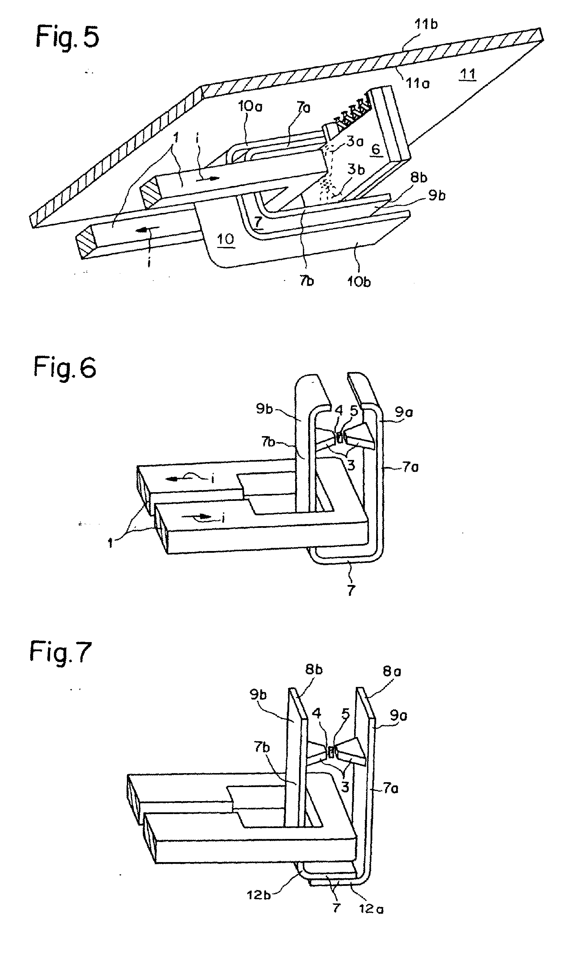

Das erste Mittel 7 weist senkrecht zu seiner Breite B bevorzugt einen im grossen Ganzen U-förmigen Querschnitt auf. Die beiden Seitenflächen 7a und 7b des ersten Mittels 7 sind dann gegenüberliegend parallel zueinander angeordnet. Die Ecken des U-förmigen Querschnitts des Mittels 7 sind z. B. annähernd rechtwinklig, ggf. leicht abgerundet. In einer in der Fig. 6 dargestellten zweiten Variante ist zusätzlich jeweils das freie Ende 9a bzw. 9b der beiden Seitenflächen 7a und 7b des ersten Mittels 7 mindestens teilweise nach innen abgebogen. Aussen parallel und magnetisch kontaktlos zum ersten Mittel 7 ist fakultativ ein mindestens annähernd gleich grosses zweites Mittel 10 aus ferromagnetischem Material angeordnet, welches somit, parallel zu den Seitenflächen 7a und 7b, je eine zu den letzteren gehörige Seitenfläche 10a bzw. 10b besitzt (siehe Fig.2 bis Fig. 5). Das zweite Mittel 10 dient als zusätzliche magnetische Abschirmung, die den Magnetfeldsensor 5 gegen den Einfluss externer magnetischer Störfelder schützt. Das ferromagnetische Material der beiden Mittel 7 und 10 ist z. B. blechförmiges ferromagnetisches Metall oder ferromagnetische Keramik. Die balkonartig vorstehenden freien Ende 9a und 9b der Seitenflächen 7a und 7b sowie die Tatsache, dass das erste Mittel 7 aus ferromagnetischem Material besteht, dessen Breite B grösser ist als die grösste Breite b des Stegs 3, ergeben einen sehr guten frontalen und seitlichen Schutz des Magnetfeldsensors 5 gegen den Einfluss äusserer magnetischer Störfelder. Dieser Schutz, obwohl in der Regel bereits genügend, wird noch verstärkt durch die Anwesenheit des nur fakultativ vorhandenen zweiten Mittels 10, welches nur als magnetische Abschirmung dient und den Magnetfeldsensor 5 gegen einen noch verbleibenden Einfluss der äusseren magnetischen Störfelder schützt.

Der Leiter 1 umgibt in allen Varianten eine Fläche des ersten Mittels 7 (siehe Fig. 1 und Fig. 6 bis Fig. 10) und, falls vorhanden, auch eine Fläche des zweiten Mittels 10 (siehe Fig. 2 bis Fig. 5) mit mindestens einer halben Windung so, dass der in ihm fliessende elektrische Strom i in den durch den Steg 3 und das erste Mittel 7 gebildeten ferromagnetischen Magnetkreis 2 den Magnetfluss Φ erzeugt. Wenn der Leiter U-förmig ist, ist er entweder so gebogen oder er besteht, wie in der Zeichnung dargestellt, aus einem flachen Stanzteil, in dem eine Öffnung als Durchgang für die Flächen der beiden Mittel 7 und 10 gestanzt ist. Im letzteren Fall ist die Öffnung nach aussen hin durch einen Schlitz verlängert, der einen Hinleiter 1a des Leiters 1 von dessen Rückleiter 1b trennt.

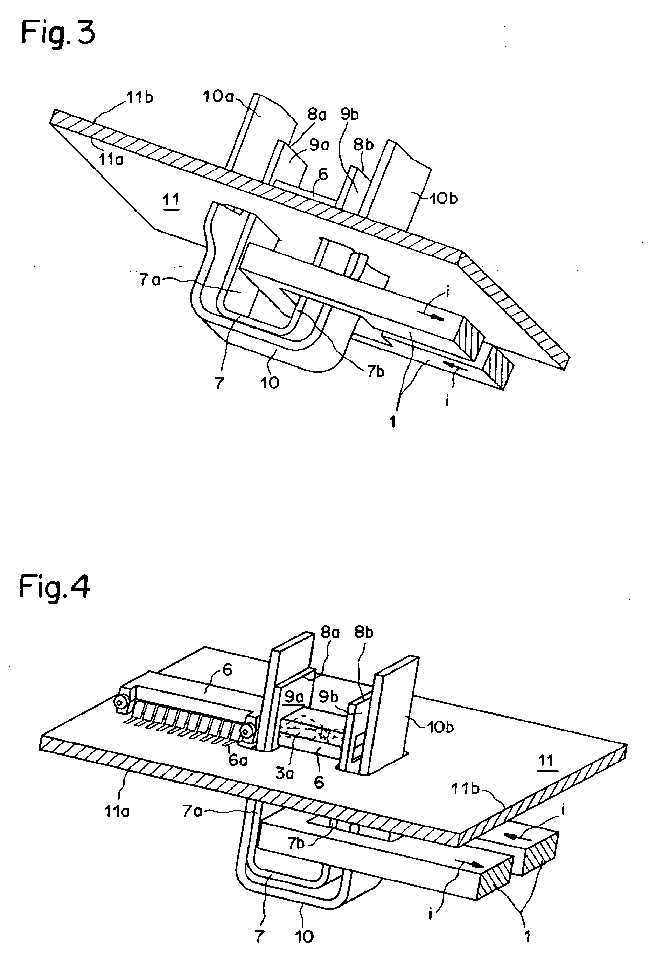

Der ferromagnetische Magnetkreis 2 ist in allen Varianten bevorzugt auf einer Leiterplatte 11 angeordnet. Die Seitenflächen 7a und 7b bzw. 10a und 10b eines oder beider Mittel 7 und/oder 10 sind dann im ersten und zweiten Aufbau (siehe Fig. 2 bis Fig. 4) auf einer ersten Seite 11a der Leiterplatte 11 annähernd senkrecht zur letzteren gesteckt angeordnet, während ihre freien Enden, 9a und 9b im Falle des ersten Mittels 7, auf der anderen, zweiten Seite 11b der Leiterplatte 11 herausragend vorstehend angeordnet sind. Der ferromagnetische Steg 3 ist in diesem Fall auf einer der beiden Seiten 11a bzw. 11b der Leiterplatte 11 zwischen den beiden Seitenflächen 7a und 7b des ersten Mittels 7 angeordnet. Wenn der ferromagnetische Steg 3 mit dem Magnetfeldsensor 5 in dem mit den elektrischen Anschlüssen 6a versehenen Gehäuse 6 enthalten ist, ist das letztere also ebenfalls mindestens teilweise zwischen den beiden Seitenflächen 7a und 7b des ersten Mittels 7 auf einer der beiden Seiten 11a oder 11b der Leiterplatte 11 angeordnet. In den Darstellungen der Fig. 2 bis Fig. 4 ist der Steg 3 und das Gehäuse 6 z. B. auf der Seite 11b der Leiterplatte 11 vorhanden. Der Hauptunterschied zwischen dem ersten Aufbau (Fig. 2, Fig. 3) und dem zweiten Aufbau (Fig. 4) besteht darin, dass das Gehäuse 6 um 90° gedreht angeordnet ist: Im ersten Aufbau ist die Längsachse des Gehäuses 6 parallel zu den Seitenflächen 7a und 7b ausgerichtet, während sie im zweiten Aufbau senkrecht quer zu denselben ausgerichtet ist. Im letzteren Fall durchquert das Gehäuse 6 eine der Seitenflächen, z. B. 7a, des ersten Mittels 7. In beiden Aufbauarten ist jeweils ein Teil des Gehäuses 6, der keine Anschlüsse 6a aufweist, zwischen den Seitenflächen 7a und 7b angeordnet.

Der in der Fig, 5 dargestellte dritte Aufbau entspricht annähernd dem ersten Aufbau mit dem Hauptunterschied, dass die Seitenflächen 7a, 7b, 10a und 10b der beiden Mittel 7 und 10 parallel zur Leiterplatte 11 angeordnet sind. Dabei befinden sich die beiden Mittel 7 und 10 bevorzugt auf eine der beiden Seiten der Leiterplatte 11, z. B. auf der Seite 11a. In diesem Fall ist eine der Seitenflächen 10a bzw. 10b des zweiten Mittels 10 (siehe Fig. 5) oder, falls dieses fehlt, eine der Seitenflächen 7a bzw. 7b des ersten Mittels 7 (in der Zeichnung nicht dargestell) auf einer der Seiten 11a bzw. 11b der Leiterplatte 11 aufliegend angeordnet.

Die elektrischen Anschlüsse 6a des Gehäuses 6 sind in allen Varianten so ausgebildet, dass das Gehäuse 6 entweder auf der Leiterplatte 11 normal lötbar gesteckt (siehe Fig. 5) oder mittels eines sogenannten SMT-Lötverfahrens ("Surface Mounted Technology") auf der Leiterplatte 11 montierbar ist (siehe Fig. 2 und Fig. 4).

In einer dritten erfindungsgemässen Variante besteht mindestens eines der beiden Mittel 7 oder 10 aus zwei Teilen 12a und 12b. In der Fig. 7 gilt die Annahme, dass das erste Mittel 7 aus zwei Teilen 12a und 12b besteht. Die beiden Teile 12a und 12b sind jeweils teilweise überlappend aufeinanderliegend so angeordnet, dass nichtüberlappende Bereiche beider Teile 12a und 12b auf der Höhe des ferromagnetischen Stegs 3 annähernd parallel zueinander sind. Die beiden Teile 12a und 12b weisen senkrecht zur Breite B des Mittels 7 vorzugsweise je einen J- oder L-förmigen Querschnitt auf und sind mindestens teilweise überlappend aufeinanderliegend so angeordnet, dass beide Teile 12a und 12b zusammen einen annähernd U-förmigen Querschnitt besitzen. In der Fig. 7 gilt die Annahme, dass beide Teile 12a und 12b je einen L-förmigen Querschnitt mit abgerundeten Kanten aufweisen.

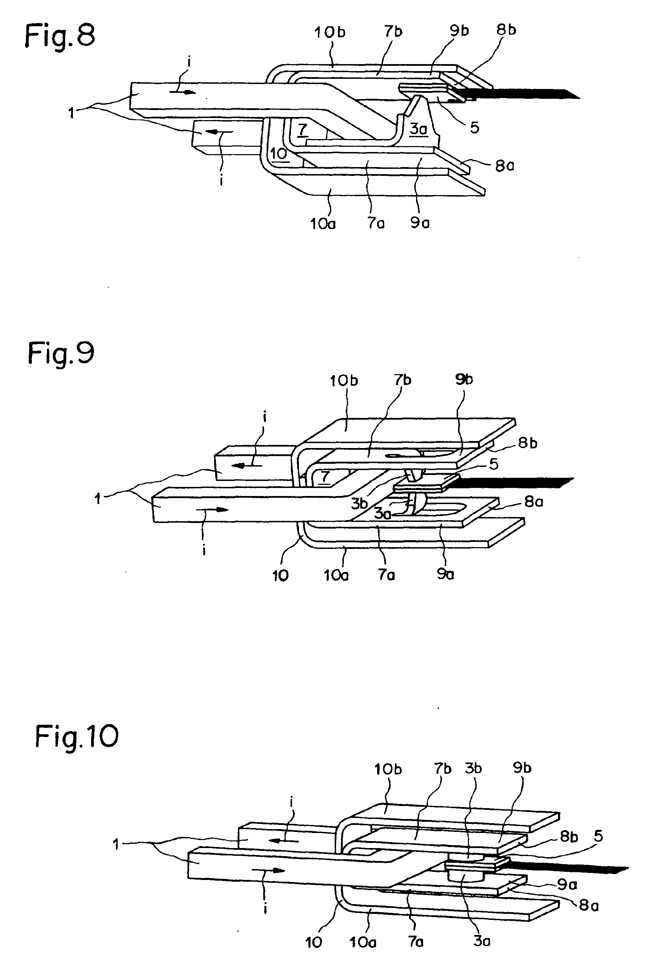

Der ferromagnetische Steg 3 besteht je nach Variante aus einem einzigen Stegteil 3a (siehe Fig. 8) oder aus zwei Stegteilen 3a und 3b (siehe alle anderen Figuren). Im ersteren Fall ist der den Magnetfeldsensor 5 enthaltende Luftspalt 4 zwischen dem einzigen Stegteil 3a und einer der beiden Seitenflächen 7a bzw. 7b des ersten Mittels 7 vorhanden. In der Fig. 8 ist der Luftspalt 4 z. B. zwischen dem einzigen Stegteil 3a und der Seitenfläche 7b angeordnet. Wenn der Steg 3 dagegen aus zwei Stegteilen 3a und 3b besteht, ist der den Magnetfeldsensor 5 enthaltende Luftspalt 4 vorzugsweise zwischen den beiden Stegteilen 3a und 3b angeordnet, wobei die Mittellinie des einen Stegteils 3a sich vorzugsweise in Verlängerung der Mittellinie des andern Stegteils 3b befindet. Das Stegteil 3a bzw. 3b ist in einer vierten und fünften Variante jeweils entweder ein aus einer der beiden Seitenflächen 7a bzw. 7b des ersten Mittels 7 nach Innen herausgebogenes balkonartig vorstehendes Biegeteil (siehe Fig. 9) oder es ist jeweils ein auf einer Innenseite einer der beiden Seitenflächen 7a bzw. 7b des ersten Mittels 7 angeordnetes Montageteil mit vorzugsweise L-förmigem Querschnitt (siehe Fig. 8), wobei eine Seite des Montageteils auf die betreffende Seitenfläche 7a bzw. 7b aufliegend montiert ist, während die andere Seite des Montageteils balkonartig vorstehend nach Innen weist.

An den Nahtstellen des ferromagnetischen Stegs 3 zum ersten Mittel 7 kann je ein weiterer Luftspalt vorhanden sein, welcher jedoch in seiner Wirkung vernachlässigbar klein gegenüber dem Einfluss des Lustspaltes 4 ist, in dem der Magnetfeldsensor 5 angeordnet ist. Dies umsomehr, wenn der Steg 3 bzw. die Stegteile 3a und 3b so ausgebildet sind, dass sie in der Nähe des Luftspaltes 4 einen kleineren Querschnitt aufweisen als in der Nähe des ersten Mittels 7. Der Luftspalt 4 ist dann in seiner Wirkung dominierend im Vergleich zu den anderen, weiteren Luftspalten. Ein Querschnitt des Stegteils 3a bzw. 3b ist daher in der Nähe des den Magnetfeldsensor 5 enthaltenden Luftspaltes 4 vorzugsweise jeweils kleiner als der Querschnitt am seinem andern Ende. Die Verengung des Stegteils 3a bzw. 3b kann dabei auf beliebige Weise erfolgen. Die Draufsicht des Stegteils 3a bzw. 3b (siehe Fig. 1 bis Fig. 7) oder eines Ende des Stegteils 3a bzw. 3b (siehe Fig. 8 und Fig. 9) ist z. B zur Realisierung der Verengung trapezförmig, wobei die parallelen Seite des Trapezes jeweils parallel zu den Seitenflächen 7a und 7b verlaufen. In einer sechsten erfindungsgemässen Variante (siehe Fig. 10) ist das Stegteil 3a bzw. 3b jeweils tablettenförmig und auf einer Innenseite einer der beiden Seitenflächen 7a bzw. 7b des ersten Mittels 7 mit seiner Rotationsachse senkrecht zu derselben angeordnet.

## Patentansprüche

1. Anordnung zur Erzielung einer zu einem elektrischen Strom (i) proportionalen magnetischen Induktion am Ort eines Magnetfeldsensors (5) mit einem elektrischen Leiter (1) zum Leiten des elektrischen Stromes (i) und einem Magnetkreis (2) aus ferromagnetischem Material zur Aufnahme eines durch den elektrischen Strom (i) erzeugten Magnetflusses (Φ), wobei der Magnetkreis (2) einen Luftspalt (4), der den Magnetfeldsensor (5) enthält, sowie einen ferromagnetischen Steg (3) aufweist, wobei zwecks Bildung eines geschossenen Magnetkreises (2) der ferromagnetische Steg (3) an einem ersten Mittel (7) aus ferromagnetischem Material angeordnet ist und wobei das erste Mittel (7) mindestens zwei gegenüberliegende parallele Teilflächen aufweist, zu denen je eine Seitenfläche (7a, 7b) des ersten Mittels (7) gehört, **dadurch gekennzeichnet, dass** die Breite (B) des ersten Mittels (7) grösser ist als eine grösste Breite (b) des ferromagnetischen Stegs (3), dass die beiden Seitenflächen (7a, 7b) parallel zur Breite (b) des ferromagnetischen Stegs (3) je eine freie Kante (8a, 8b) aufweisen, die jeweils ein vorstehendes freies Ende (9a, 9b) der betreffenden Seitenfläche (7a, 7b) begrenzt, und dass der ferromagnetische Steg (3) in einem Abstand (d) zu den freien Kanten (8a, 8b) der beiden Seitenflächen (7a, 7b) angeordnet ist, wobei dieser Abstand (d) zu den freien Kanten (8a, 8b) annähernd 1/3 einer Gesamtlänge (L) der Seitenfläche (7a, 7b) ist und wobei der ferromagnetische Steg (3) annähernd in der Mitte der Breite (B) des ersten Mittels (7) zwischen den parallelen Teilflächen angeordnet ist.

2. Anordnung nach Anspruch 1, **dadurch gekennzeichnet, dass** das erste Mittel (7) senkrecht zu seiner Breite (B) einen im grossen Ganzen U-förmigen Querschnitt aufweist.

3. Anordnung nach Anspruch 1 oder 2, **dadurch gekennzeichnet, dass** zusätzlich das freie Ende (9a, 9b) der beiden Seitenflächen (7a, 7b) des ersten Mittels (7) jeweils mindestens teilweise nach innen abgebogen ist.

4. Anordnung nach einem der Ansprüche 1 bis 3, **dadurch gekennzeichnet, dass** aussen parallel und magnetisch kontaktlos zum ersten Mittel (7) ein mindestens annähernd gleich grosses zweites Mittel (10) aus ferromagnetischem Material angeordnet ist.

5. Anordnung nach einem der Ansprüche 1 bis 4, **dadurch gekennzeichnet, dass** mindestens ein Mittel (7, 10) aus zwei Teilen (12a, 12b) besteht, die teilweise überlappend aufeinanderliegend so angeordnet sind, dass nichtüberlappende Bereiche beider Teile (12a, 12b) auf der Höhe des ferromagnetischen Stegs (3) annähernd parallel zueinander sind.

6. Anordnung nach Anspruch 5, **dadurch gekennzeichnet, dass** die beiden Teile (12a, 12b) je einen J-oder L-förmigen Querschnitt aufweisen und mindestens teilweise überlappend aufeinanderliegend so angeordnet sind, dass beide Teile (12a, 12b) zusammen einen annähernd U-förmigen Querschnitt besitzen.

7. Anordnung nach einem der Ansprüche 1 bis 6, **dadurch gekennzeichnet, dass** der ferromagnetische Steg (3) aus einem einzigen Stegteil (3a) besteht und dass der den Magnetfeldsensor (5) enthaltende Luftspalt (4) zwischen dem einzigen Stegteil (3a) und einer der beiden Seitenflächen (7a, 7b) des ersten Mittels (7) vorhanden ist.

8. Anordnung nach einem der Ansprüche 1 bis 6, **dadurch gekennzeichnet, dass** der ferromagnetische Steg (3) aus zwei Stegteilen (3a, 3b) besteht, zwischen denen der den Magnetfeldsensor (5) enthaltende Luftspalt (4) angeordnet ist, wobei die Mittellinie des einen Stegteils (3a) sich in Verlängerung der Mittellinie des andern Stegteils (3b) befindet.

9. Anordnung nach Anspruch 7 oder 8, **dadurch gekennzeichnet, dass** das Stegteil (3a, 3b) jeweils ein aus einer der beiden Seitenflächen (7a, 7b) des ersten Mittels (7) nach innen herausgebogenes balkonartig vorstehendes Biegeteil ist.

10. Anordnung nach Anspruch 7 oder 8, **dadurch gekennzeichnet, dass** das Stegteil (3a, 3b) jeweils ein auf einer Innenseite einer der beiden Seitenflächen (7a, 7b) des ersten Mittels (7) angeordnetes Montageteil mit L-förmigem Querschnitt ist, wobei eine Seite des Montageteils auf die betreffende Seitenfläche (7a, 7b) aufliegend montiert ist, während die andere Seite des Montageteils vorstehend nach innen weist.

11. Anordnung nach einem der Ansprüche 7 bis 10, **dadurch gekennzeichnet, dass** ein Querschnitt des Stegteils (3a, 3b) in der Nähe des den Magnetfeldsensor (5) enthaltenden Luftspaltes (4) jeweils kleiner ist als der Querschnitt an seinem andern Ende.

12. Anordnung nach Anspruch 7 oder 8, **dadurch gekennzeichnet, dass** das Stegteil (3a, 3b) jeweils tablettenförmig und auf einer Innenseite einer der beiden Seitenflächen (7a, 7b) des ersten Mittels (7) mit seiner Rotationsachse senkrecht zu derselben angeordnet ist.

13. Anordnung nach einem der Ansprüche 1 bis 12, **dadurch gekennzeichnet, dass** der ferromagnetische Magnetkreis (2) auf einer Leiterplatte (11) angeordnet ist.

14. Anordnung nach Anspruch 13, **dadurch gekennzeichnet, dass** die Seitenflächen (7a, 7b bzw. 10a, 10b) eines oder beider Mittel (7, 10) auf einer ersten Seite (11a) der Leiterplatte (11) annähernd senkrecht zur letzteren gesteckt angeordnet sind, wobei ihre freien Enden (z. B. 9a, 9b) auf der anderen, zweiten Seite (11b) der Leiterplatte (11) herausragend vorstehend angeordnet sind, und dass der ferromagnetische Steg (3) auf einer der beiden Seiten (11a, 11b) der Leiterplatte (11) zwischen den beiden Seitenflächen (7a, 7b) des ersten Mittels (7) angeordnet ist.

15. Anordnung nach Anspruch 13, **dadurch gekennzeichnet, dass** eine der Seitenflächen (10a, 10b) des zweiten Mittels (10) oder, falls dieses fehlt, eine der Seitenflächen (7a, 7b) des ersten Mittels (7) auf einer Seite (11a, 11b) der Leiterplatte (11) aufliegend angeordnet ist.

16. Anordnung nach einem der Ansprüche 1 bis 15, **dadurch gekennzeichnet, dass** der ferromagnetische Steg (3) in einem mit elektrischen Anschlüssen (6a) versehenen Gehäuse (6) aus nichtferromagnetischem Material enthalten ist, welches mindestens teilweise zwischen den beiden Seitenflächen (7a, 7b) des ersten Mittels (7) angeordnet ist.

17. Anordnung nach Anspruch 16, **dadurch gekennzeichnet, dass** das Gehäuse (6) auf einer Seite (11a, 11b) einer Leiterplatte (11) angeordnet ist.

18. Anordnung nach Anspruch 16 oder 17, **dadurch gekennzeichnet, dass** die elektrischen Anschlüsse (6a) des Gehäuses (6) so ausgebildet sind, dass das Gehäuse (6) mittels eines SMT-Lötverfahrens ("Surface Mounted Technology") auf einer Leiterplatte (11) montierbar ist.

## Claims

1. Arrangement for achieving magnetic induction, proportional to an electric current (i), at the location of a magnetic field sensor (5) by means of an electrical conductor (1) for carrying the electric current (i) and a magnetic circuit (2) composed of ferromagnetic material for receiving a magnetic flux (Φ) produced by the electric current (i), with the magnetic circuit (2) having an air gap (4), which contains the magnetic field sensor (5), as well as a ferromagnetic web (3), in which case, in order to form a closed magnetic circuit (2), the ferromagnetic web (3) is arranged on a first means (7) composed of ferromagnetic material, and with the first means (7) having at least two opposite parallel surface elements, each of which is associated with a side surface (7a, 7b) of the first means (7), **characterized in that** the width (B) of the first means (7) is greater than the maximum width (b) of the ferromagnetic web (3), **in that** the two side surfaces (7a, 7b) respectively have a free edge (8a, 8b) parallel to the width (b) of the ferromagnetic web (3), which free edge respectively bounds a projecting free end (9a, 9b) of the relevant side surface (7a, 7b), and **in that** the ferromagnetic web (3) is arranged at a distance (d) from the free edges (8a, 8b) of the two side surfaces (7a, 7b), with this distance (d) to the free edges (8a, 8b) being approximately 1/3 of the overall length (L) of the side surface (7a, 7b), and with the ferromagnetic web (3) being arranged approximately at the centre of the width (B) of the first means (7) between the parallel surface elements.

2. Arrangement according to Claim 1, **characterized in that** the first means (7) comprises a substantially U-shaped cross section at right angles to its width (B).

3. Arrangement according to Claim 1 or 2, **characterized in that** the free end (9a, 9b) of the two side surfaces (7a, 7b) of the first means (7) is additionally in each case at least partially bent inwards.

4. Arrangement according to one of Claims 1 to 3, **characterized in that** a second means (10) which is at least approximately of the same size and is composed of ferromagnetic material is arranged externally parallel to, and magnetically without any contact with, the first means (7).

5. Arrangement according to one of Claims 1 to 4, **characterized in that** at least one means (7, 10) comprises two parts (12a, 12b) which are arranged partially overlapping on one another such that non-overlapping areas of the two parts (12a, 12b) are approximately parallel to one another at the same level as the ferromagnetic web (3).

6. Arrangement according to Claim 5, **characterized in that** the two parts (12a, 12b) each have a J-shaped or L-shaped cross section and are arranged at least partially overlapping on one another such that the two parts (12a, 12b) together have an approximately U-shaped cross section.

7. Arrangement according to one of Claims 1 to 6, **characterized in that** the ferromagnetic web (3) comprises a single web part (3a), and **in that** the air gap (4) which contains the magnetic field sensor (5) is provided between the single web part (3a) and one of the two side surfaces (7a, 7b) of the first means (7).

8. Arrangement according to one of Claims 1 to 6, **characterized in that** the ferromagnetic web (3) comprises two web parts (3a, 3b), between which the air gap (4) which contains the magnetic field sensor (5) is arranged, with the centre line of one web part (3a) being located on an extension of the centre line of the other web part (3b).

9. Arrangement according to Claim 7 or 8, **characterized in that** the web part (3a, 3b) is in each case a bent part which projects like a balcony and is bent inwards out of one of the two side surfaces (7a, 7b) of the first means (7).

10. Arrangement according to Claim 7 or 8, **characterized in that** the web part (3a, 3b) is in each case a mounting part, which is arranged on an inner face of one of the two side surfaces (7a, 7b) of the first means (7) and has an L-shaped cross section, with one side of the mounting part being mounted such that it rests on the appropriate side surface (7a, 7b), while the other side of the mounting part projects pointing inwards.

11. Arrangement according to one of Claims 7 to 10, **characterized in that** a cross section of the web part (3a, 3b) in the vicinity of the air gap (4) which contains the magnetic field sensor (5) is in each case smaller than the cross section at its other end.

12. Arrangement according to Claim 7 or 8, **characterized in that** the web part (3a, 3b) is in each case in the form of a tablet and is arranged on an inner face of one of the two side surfaces (7a, 7b) of the first means (7) with its rotation axis at right angles thereto.

13. Arrangement according to one of Claims 1 to 12, **characterized in that** the ferromagnetic circuit (2) is arranged on a printed circuit board (11).

14. Arrangement according to Claim 13, **characterized in that** the respective side surfaces (7a, 7b) or (10a, 10b) of one or both means (7, 10) are arranged on a first side (11 a) of the printed circuit board (11), plugged in approximately at right angles to the latter, with their free ends (for example 9a, 9b) being arranged such that they project on the other, second side (11b) of the printed circuit board (11), and **in that** the ferromagnetic web (3) on one of the two sides (11 a, 11 b) of the printed circuit board (11) is arranged between the two side surfaces (7a, 7b) of the first means (7).

15. Arrangement according to Claim 13, **characterized in that** one of the side surfaces (10a, 10b) of the second means (10) or, if this is not present, one of the side surfaces (7a, 7b) of the first means (7), is arranged resting on one side (11 a, 11b) of the printed circuit board (11).

16. Arrangement according to one of Claims 1 to 15, **characterized in that** the ferromagnetic web (3) is contained in a housing (6) which is provided with electrical connections (6a) and is composed of non-ferromagnetic material, and is arranged at least partially between the two side surfaces (7a, 7b) of the first means (7).

17. Arrangement according to Claim 16, **characterized in that** the housing (6) is arranged on one side (11a, 11b) of a printed circuit board (11).

18. Arrangement according to Claim 16 or 17, **characterized in that** the electrical connections (6a) of the housing (6) are designed such that the housing (6) can be mounted on a printed circuit board (11) using a surface mounted technology (SMT) soldering process.

## Revendications

1. Dispositif pour obtenir une induction magnétique proportionnelle à un courant électrique (i) à l'emplacement d'un capteur de champ magnétique (5) avec un conducteur électrique (1) pour conduire le courant électrique (i) et un circuit magnétique (2) en matériau ferromagnétique pour recevoir un flux magnétique (Φ) généré par le courant électrique (i), le circuit magnétique (2) présentant un entrefer (4) qui contient le capteur de champ magnétique (5) ainsi qu'une branche ferromagnétique (3), la branche ferromagnétique (3) étant disposée sur un premier moyen (7) en matériau ferromagnétique en vue de former un circuit magnétique (2) fermé et le premier moyen (7) présentant au moins deux surfaces partielles parallèles situées l'une en face de l'autre, à chacune desquelles appartient une surface latérale (7a, 7b) du premier moyen (7), **caractérisé en ce que** la largeur (B) du premier moyen (7) est plus grande qu'une plus grande largeur (b) de la branche ferromagnétique (3), que les deux surfaces latérales (7a, 7b) présentent chacune une arête libre (8a, 8b) parallèle à la largeur (b) de la branche ferromagnétique (3), qui limite une extrémité libre saillante (9a, 9b) de la surface latérale (7a, 7b) concernée, et que la branche ferromagnétique (3) est disposée à une distance (d) des arêtes libres (8a, 8b) des deux surfaces latérales (7a, 7b), cette distance (d) par rapport aux arêtes libres (8a, 8b) étant approximativement de 1/3 d'une longueur totale (L) de la surface latérale (7a, 7b) et la branche ferromagnétique (3) étant disposée approximativement au milieu de la largeur (B) du premier moyen (7) entre les surfaces partielles parallèles.

2. Dispositif selon la revendication 1, **caractérisé en ce que** le premier moyen (7) présente perpendiculairement à sa largeur (B) en gros une section en forme de U.

3. Dispositif selon la revendication 1 ou 2, **caractérisé en ce que** l'extrémité libre (9a, 9b) de chacune des deux surfaces latérales (7a, 7b) du premier moyen (7) est, en plus, au moins partiellement pliée vers l'intérieur.

4. Dispositif selon l'une des revendications 1 à 3, **caractérisé en ce qu'**extérieurement et parallèlement au premier moyen (7), sans contact magnétique avec lui, est disposé un deuxième moyen (10) en matériau ferromagnétique au moins approximativement aussi grand que lui.

5. Dispositif selon l'une des revendications 1 à 4, **caractérisé en ce qu'**au moins un moyen (7, 10) est composé de deux parties (12a, 12b) qui sont disposées l'une sur l'autre en se recouvrant partiellement de façon que des zones non recouvrantes des deux parties (12a, 12b) soient approximativement parallèles l'une à l'autre à hauteur de la branche ferromagnétique (3).

6. Dispositif selon la revendication 5, **caractérisé en ce que** les deux parties (12a, 12b) présentent chacune une section en J ou en L et sont disposées l'une sur l'autre en se recouvrant au moins partiellement de façon que les deux parties (12a, 12b) possèdent ensemble une section approximativement en U.

7. Dispositif selon l'une des revendications 1 à 6, **caractérisé en ce que** la branche ferromagnétique (3) est composée d'une unique partie de branche (3a) et que l'entrefer (4) contenant le capteur de champ magnétique (5) est présent entre l'unique partie de branche (3a) et une des deux surfaces latérales (7a, 7b) du premier moyen (7).

8. Dispositif selon l'une des revendications 1 à 6, **caractérisé en ce que** la branche ferromagnétique (3) est composée de deux parties de branche (3a, 3b) entre lesquelles l'entrefer (4) contenant le capteur de champ magnétique (5) est disposé, la ligne médiane d'une partie de branche (3a) se trouvant dans le prolongement de la ligne médiane de l'autre partie de branche (3b).

9. Dispositif selon la revendication 7 ou 8, **caractérisé en ce que** chaque partie de branche (3a, 3b) est une pièce pliée vers l'intérieur à partir d'une des deux surfaces latérales (7a, 7b) du premier moyen (7) et qui fait saillie à la manière d'un balcon.

10. Dispositif selon la revendication 7 ou 8, **caractérisé en ce que** chaque partie de branche (3a, 3b) est une pièce de montage à section en L disposée sur un côté intérieur d'une des deux surfaces latérales (7a, 7b) du premier moyen (7), un côté de la pièce de montage étant monté en applique sur la surface latérale (7a, 7b) concernée, tandis que l'autre côté de la pièce de montage fait saillie vers l'intérieur.

11. Dispositif selon l'une des revendications 7 à 10, **caractérisé en ce qu'**une section de chaque partie de branche (3a, 3b) à proximité de l'entrefer (4) contenant le capteur de champ magnétique (5) est plus petite que la section à son autre extrémité.

12. Dispositif selon la revendication 7 ou 8, **caractérisé en ce que** chaque partie de branche (3a, 3b) est en forme de comprimé et disposée sur un côté intérieur d'une des deux surfaces latérales (7a, 7b) du premier moyen (7) avec son axe de rotation perpendiculaire à celle-ci.

13. Dispositif selon l'une des revendications 1 à 12, **caractérisé en ce que** le circuit magnétique ferromagnétique (2) est disposé sur une carte de circuit imprimé (11).

14. Dispositif selon la revendication 13, **caractérisé en ce que** les surfaces latérales (7a, 7b ou 10a, 10b) d'un ou des deux moyens (7, 10) sont disposées d'un premier côté (11 a) de la carte de circuit imprimé (11) en étant enfichées approximativement perpendiculairement à cette dernière, leurs extrémités libres (par exemple 9a, 9b) étant disposées de l'autre ou deuxième côté (11 b) de la carte de circuit imprimé (11) en faisant saillie de celle-ci, et que la branche ferromagnétique (3) est disposée d'un des deux côtés (11a, 11 b) de la carte de circuit imprimé (11) entre les deux surfaces latérales (7a, 7b) du premier moyen (7).

15. Dispositif selon la revendication 13, **caractérisé en ce qu'**une des surfaces latérales (10a, 10b) du deuxième moyen (10) ou, si celui-ci est absent, une des surfaces latérales (7a, 7b) du premier moyen (7) est disposée en applique sur un côté (11a, 11 b) de la carte de circuit imprimé (11).

16. Dispositif selon l'une des revendications 1 à 15, **caractérisé en ce que** la branche ferromagnétique (3) est contenue dans un boîtier (6) en matériau non ferromagnétique pourvu de connexions électriques (6a), lequel est disposé au moins partiellement entre les deux surfaces latérales (7a, 7b) du premier moyen (7).

17. Dispositif selon la revendication 16, **caractérisé en ce que** le boîtier (6) est disposé d'un côté (11a, 11 b) d'une carte de circuit imprimé (11).

18. Dispositif selon la revendication 16 ou 17, **caractérisé en ce que** les connexions électriques (6a) du boîtier (6) sont conçues de façon que le boîtier (6) puisse être monté sur une carte de circuit imprimé (11) au moyen d'un procédé de brasage SMT («Surface Mounted Technology »).
